# EUROPEAN PATENT APPLICATION

(11) **EP 4 687 394 A2**
(43) Date of publication of application: **04.02.2026**
(21) Application number: 25193272.9
(22) Date of filing: 31.07.2025
(51) Int. Cl.: H10B 63/10, H10N 70/20

(54) **VERTICAL CHALCOGENIDE MEMORY DEVICE AND METHOD**

(30) Priority: 31.07.2024 US 202463677639 P
(71) Applicant: Micron Technology, Inc., Boise, ID 83716-9632 (US)
(72) Inventor: FRATIN, Lorenzo, Milan (IT); FUKUZUMI, Yoshiaki, Yokohama, 232006 (JP); FANTINI, Paolo, 20871 Vimercate (IT); TESSARIOL, Paolo, 20862 Arcore (IT)
(74) Representative: Marks & Clerk LLP

(57) **Abstract**

Apparatus and methods are disclosed, including chalcogenide memory cells, semiconductor devices and systems. Example semiconductor devices and methods include a number of chalcogenide material plugs electrically isolated from one another. The number of chalcogenide material plugs are electrically coupled between conducting word line layers and a number of vertical data lines.

## Description

### BACKGROUND

Memory devices are semiconductor circuits that provide electronic storage of data for a host system (e.g., a computer or other electronic device). Memory devices may be volatile or non-volatile. Volatile memory requires power to maintain data, and includes devices such as random-access memory (RAM), static random-access memory (SRAM), dynamic random-access memory (DRAM), or synchronous dynamic random-access memory (SDRAM), among others. Non-volatile memory can retain stored data when not powered, and includes devices such as flash memory, read-only memory (ROM), electrically erasable programmable ROM (EEPROM), erasable programmable ROM (EPROM), resistance variable memory, such as chalcogenide and/or phase change random access memory (PCRAM), resistive random-access memory (RRAM), or magnetoresistive random access memory (MRAM), among others.

Host systems typically include a host processor, a first amount of main memory (e.g., often volatile memory, such as DRAM) to support the host processor, and one or more storage systems (e.g., often non-volatile memory, such as flash memory) that provide additional storage to retain data in addition to or separate from the main memory.

A storage system, such as a solid-state drive (SSD), can include a memory controller and one or more memory devices, including a number of dies or logical units (LUNs). In certain examples, each die can include a number of memory arrays and peripheral circuitry thereon, such as die logic or a die processor. The memory controller can include interface circuitry configured to communicate with a host device (e.g., the host processor or interface circuitry) through a communication interface (e.g., a bidirectional parallel or serial communication interface).

The present description relates generally to chalcogenide memory devices such as 3D vertical memory devices and manufacture.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 illustrates a memory device in accordance with some example embodiments.
FIG. 2 illustrates an alternating stack of conducting layers and dielectric layers in accordance with some example embodiments.
FIG. 3 illustrates selected portions of a memory device in accordance with some example embodiments.
FIG. 4 illustrates other selected portions of the memory device from Fig. 3 in accordance with some example embodiments.
FIG. 5 illustrates a close-up view of other selected portions of the memory device from Figs. 3 and 4 in accordance with some example embodiments.
FIG. 6A illustrates a stage of manufacture of a memory device in accordance with some example embodiments.
FIG. 6B illustrates another stage of manufacture of a memory device in accordance with some example embodiments.
FIG. 6C illustrates another stage of manufacture of a memory device in accordance with some example embodiments.
FIG. 6D illustrates another stage of manufacture of a memory device in accordance with some example embodiments.
FIG. 6E illustrates another stage of manufacture of a memory device in accordance with some example embodiments.
FIG. 6F illustrates another stage of manufacture of a memory device in accordance with some example embodiments.
FIG. 6G illustrates another stage of manufacture of a memory device in accordance with some example embodiments.
FIG. 6H illustrates another stage of manufacture of a memory device in accordance with some example embodiments.
FIG. 6I illustrates another stage of manufacture of a memory device in accordance with some example embodiments.
FIG. 6J illustrates another stage of manufacture of a memory device in accordance with some example embodiments.
FIG. 6K illustrates another stage of manufacture of a memory device in accordance with some example embodiments.
FIG. 7A illustrates a memory device in accordance with some example embodiments.
FIG. 7B illustrates a close-up view of portions of the memory device from Fig. 7A in accordance with some example embodiments.
FIG. 7C illustrates another close-up view of portions of the memory device from Fig. 7A in accordance with some example embodiments.
FIG. 8 illustrates an example method flow diagram in accordance with other example embodiments.
FIG. 9 illustrates an example block diagram of an information handling system in accordance with some example embodiments.

### DETAILED DESCRIPTION

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

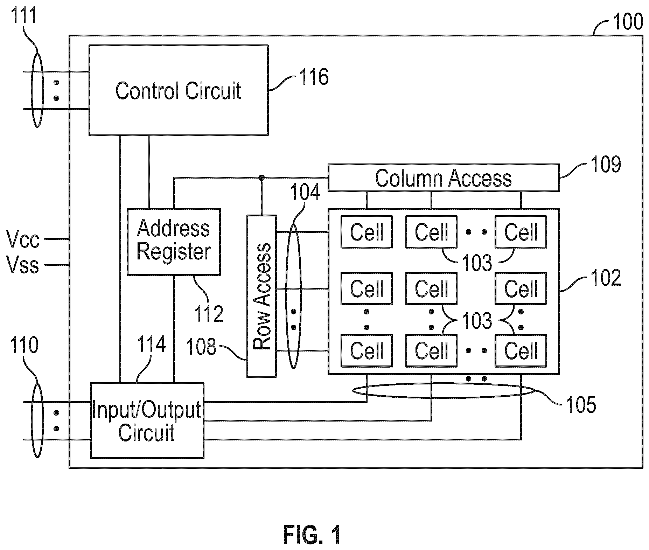

FIG. 1 shows a block diagram of an apparatus in the form of a memory device 100, according to an embodiment of the invention. Memory device 100 can include a memory array 102 having memory cells 103 that can be arranged in rows and columns along with lines (e.g., access lines) 104 and lines (e.g., data lines) 105. Memory device 100 can use lines 104 to access memory cells 103 and lines 105 to exchange information with memory cells 103.

Memory cells 103 and other circuits 114, 116, etc. may include transistors and/or chalcogenide memory cells and utilize methods as described in more detail below. In one example, memory arrays 102 include RAM storage, and peripheral circuits such as circuits 114, 116, 108, 109, etc. may include transistors and/or chalcogenide memory cells as described in more detail in below. In one example, memory arrays 102 include NAND storage.

Row access 108 and column access 109 circuitry can respond to an address register 112 to access memory cells 103 based on row address and column address signals on lines 110, 111, or both. A data input/output circuit 114 can be configured to exchange information between memory cells 103 and lines 110. Lines 110 and 111 can include nodes within memory device 100 or pins (or solder balls) on a package where memory device 100 can reside.

A control circuit 116 can control operations of memory device 100 based on signals present on lines 110 and 111. A device (e.g., a processor or a memory controller) external to memory device 100 can send different commands (e.g., read, write, or erase commands) to memory device 100 using different combinations of signals on lines 110, 111, or both.

Memory device 100 can respond to commands to perform memory operations on memory cells 103, such as performing a read operation to read information from memory cells 103 or performing a write (e.g., programming) operation to store (e.g., program) information into memory cells 103. Memory device 100 can also perform an erase operation to clear information from some or all of memory cells 103.

Memory device 100 can receive a supply voltage, including supply voltages Vcc and Vss. Supply voltage Vss can operate at a ground potential (e.g., having a value of approximately zero volts). Supply voltage Vcc can include an external voltage supplied to memory device 100 from an external power source such as a battery or an alternating-current to direct-current (AC-DC) converter circuitry.

Each of memory cells 103 can be programmed to store information representing a value of a fraction of a bit, a value of a single bit, or a value of multiple bits such as two, three, four, or another number of bits. For example, each of memory cells 103 can be programmed to store information representing a binary value "0" or "1" of a single bit. The single bit per cell is sometimes called a single level cell. In another example, each of memory cells 103 can be programmed to store information representing a value for multiple bits, such as one of four possible values "00," "01," "10," and "11" of two bits, one of eight possible values "000," "001," "010," "011," "100," "101," "110," and "111" of three bits, or one of other values of another number of multiple bits. A cell that has the ability to store multiple bits is sometimes called a multi-level cell (or multi-state cell).

Memory device 100 can include a non-volatile memory device, and memory cells 103 can include non-volatile memory cells, such that memory cells 103 can retain information stored thereon when power (e.g., Vcc, Vss, or both) is disconnected from memory device 100. For example, memory device 100 can be a flash memory device, such as a NAND flash or a NOR flash memory device, or another kind of memory device, such as a variable resistance memory device (e.g., a chalcogenide or resistive RAM device).

Memory device 100 can include a memory device where memory cells 103 can be physically located in multiple levels on the same device, such that some of memory cells 103 can be stacked over some other memory cells 103 in multiple levels over a substrate (e.g., a semiconductor substrate) of memory device 100.

One of ordinary skill in the art will recognize that memory device 100 may include other elements, several of which are not shown in FIG. 1, so as not to obscure the example embodiments described herein.

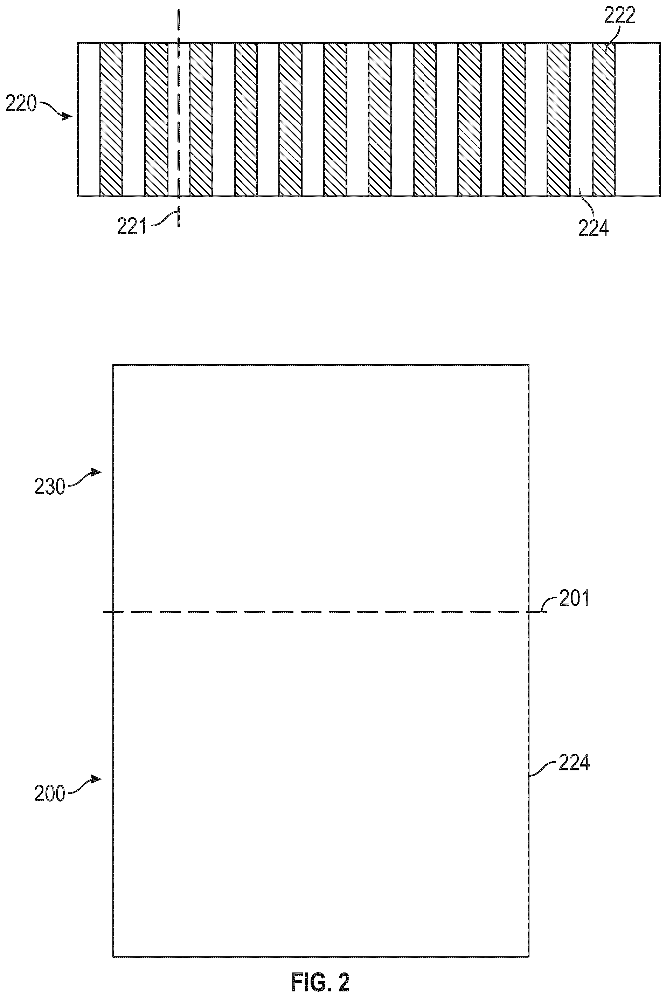

Figure 2 shows an alternating stack 200 of conducting word line layers 222 and dielectric layers 224. View 220 shows a cross section of the layers 222, 224 along line 201, and view 230 shows a cross section of a dielectric layer 224 along line 221. An alternating stack 200 as shown is used to manufacture a chalcogenide memory devices as described in the following description.

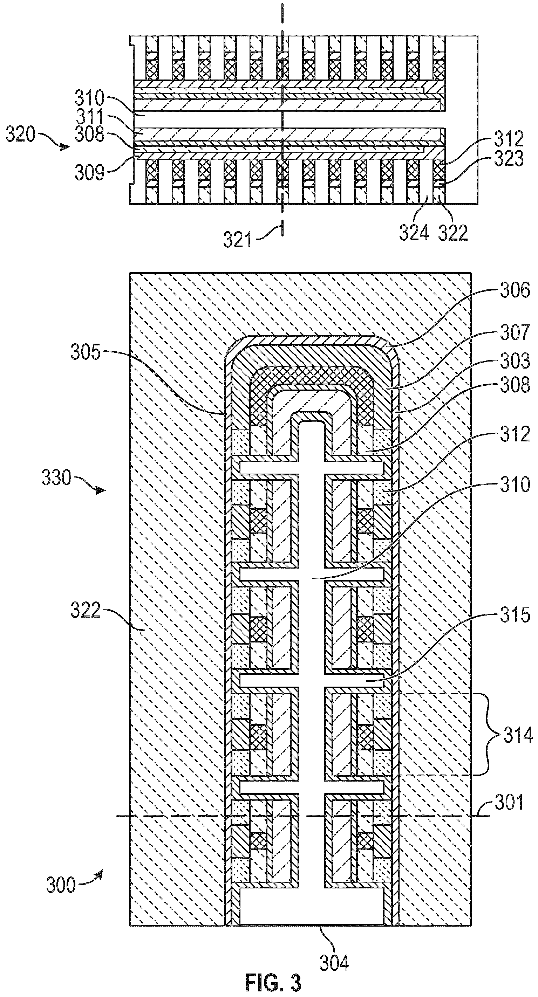

Figure 3 shows selected portions of a memory device 300 formed from alternating stack 200. A conducting word line layer 322 is shown alternating with a dielectric layer 324. View 320 shows a cross section of the layers 322, 324 along line 301, and view 330 shows a cross section of a conducting word line layer 322 along line 321.

In one example, a placeholder material word line layer 222 shown in Figure 2 has been replaced with a conductor material to make up the conducting word line layer 322. In one example, a process to form the conducting word line layer 322 is referred to as a "replacement gate" operation. In one example, a nitride material is removed, and a conducting metal is replaced within the stack 200. One example of a conducting metal includes tungsten or a tungsten alloy although the invention is not so limited.

A trench 310 is formed within the stack 200. The trench 310 includes an laterally open end 304 and a distal end 306. The trench 310 also includes a first side 303 and a second side 305. In examples described in more detail below, the open end 304 is used to introduce material layers within the trench 310 and to remove selected layers or portions of layers from within the trench 310.

A number of vertical data lines 308 are shown extending upward within the trench 310 normal to layers 322, 324 in the alternating stack of conducting word line layers and dielectric layers. In one example, the number of vertical data lines 308 include tungsten or a tungsten alloy. In one example, the vertical data lines 308 include a similar or the same material as the conducting word line layers 322. In the example of Figure 3, one or more isolation dielectric layers 311 are formed within the trench 310. The isolation dielectric layers 311 separate vertical data lines 308 on either side of the trench 310.

Figure 3 further shows a number of chalcogenide material plugs 312 electrically isolated from one another. The number of chalcogenide material plugs 312 are electrically coupled between the conducting word line layers 322 and the number of vertical data lines 308. A first sacrificial layer 307 is shown adjacent to chalcogenide material plugs 312. In one example portions of the first sacrificial layer 307 remain in the memory device 300 after formation of the chalcogenide material plugs 312. The sacrificial layer 307 wraps around an interior of the trench 310, along sides 303, 305 and around the distal end 306.

In the example of Figure 3, an intermediate additional conductor layer 323 is included between the conducting word line layers 322 and the chalcogenide material plugs 312. In one example, the additional conductor layer 323 functions as a low resistance ohmic contact between the conducting word line layers 322 and the chalcogenide material plugs 312. In one example, the additional conductor layer 323 includes a high-k material.

As used herein, the term "high-k material" means and includes a material having a dielectric constant greater than the dielectric constant of silicon dioxide (SiO₂). The high-k material may include a high-k oxide material, a high-k metal oxide material, or a combination thereof. By way of example only, the high-k material may be aluminum oxide, gadolinium oxide, hafnium oxide, niobium oxide, tantalum oxide, titanium oxide, zirconium oxide, hafnium silicate, a combination thereof, or a combination of one or more of the listed high-k materials with silicon oxide.

Similarly, In the example of Figure 3, an additional conductor layer 309 is included between the vertical data lines 308 and the chalcogenide material plugs 312. In one example, the additional conductor layer 309 functions as a low resistance ohmic contact between the vertical data lines 308 and the chalcogenide material plugs 312. In one example, the additional conductor layer 309 includes a high-k material.

The view 330 of Figure 3 further shows a memory cell pair 314. The memory cell pair 314 is formed as one of several memory cell pairs 314 on the first side 303 of the trench 310, and separated from memory cell pairs 314 on the second side 305 of the trench 310 by isolation dielectric layers 311. A lateral separator 315 is shown formed from a dielectric, and laterally isolating memory cell pairs 314 from one another along a given side 303, 305 of the trench 310.

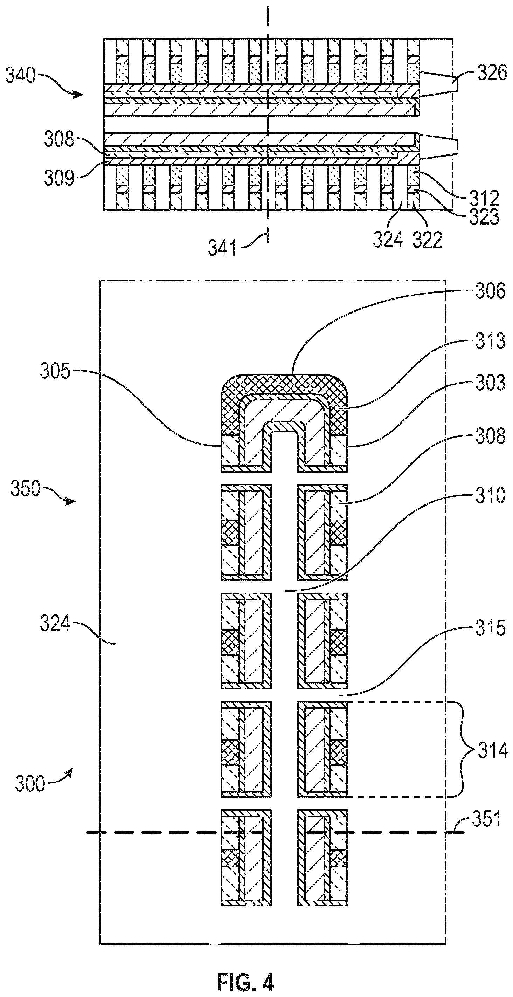

Figure 4 shows the memory device 300 from Figure 3. However, in Figure 4, view 340 shows a cross section of the layers 322, 324 along line 351, and view 350 shows a cross section of a dielectric layer 324 along line 341. Figure 4 provides additional structural details of how the memory device 300 is formed in three dimensions.

A second sacrificial layer 313 is shown adjacent to vertical data lines 308. In one example portions of the sacrificial layer 313 remain in the memory device 300 after formation of the vertical data lines 308. The sacrificial layer 313 wraps around an interior of the trench 310, along sides 303, 305 and around the distal end 306. Figure 4 also shows a pair of interconnection plugs 326 at a bottom of the memory device 300 to connect the vertical data lines 308 to additional circuitry (not shown).

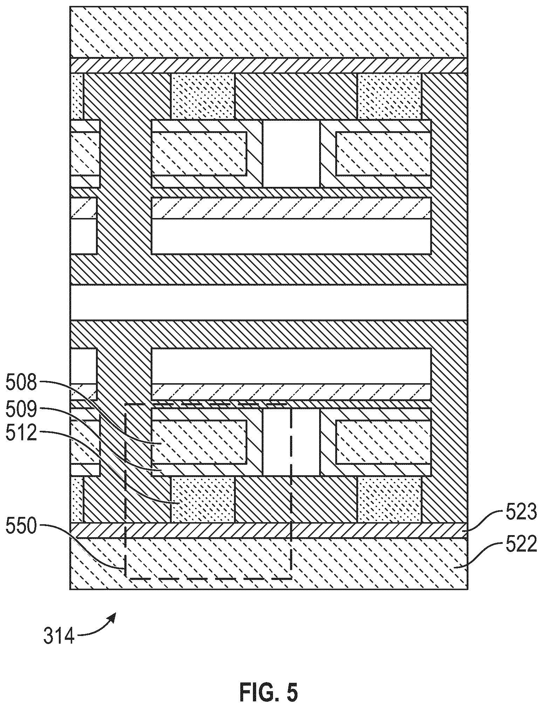

Figure 5 shows a close up view of a memory cell pair 314 as described above. In Figure 5, a single memory cell 550 is shown as part of the pair 314. A vertical data line 508 is shown, and a conducting word line layer 522. A chalcogenide material plug 512 is shown electrically coupled between the conducting word line layer 522 and the vertical data line 508. An intermediate additional conductor layer 523 is included between the conducting word line layers 522 and the chalcogenide material plug 512. An intermediate additional conductor layer 509 is also included between the vertical data line 508 and the chalcogenide material plug 512. As discussed above, in one example, the intermediate additional conductor layers 323 and 509 may include a high-k material. In the example, shown, the additional conductor layer 509 is only present on three lateral sides of the vertical data line 508. This results from the manufacturing method as described in more detail below.

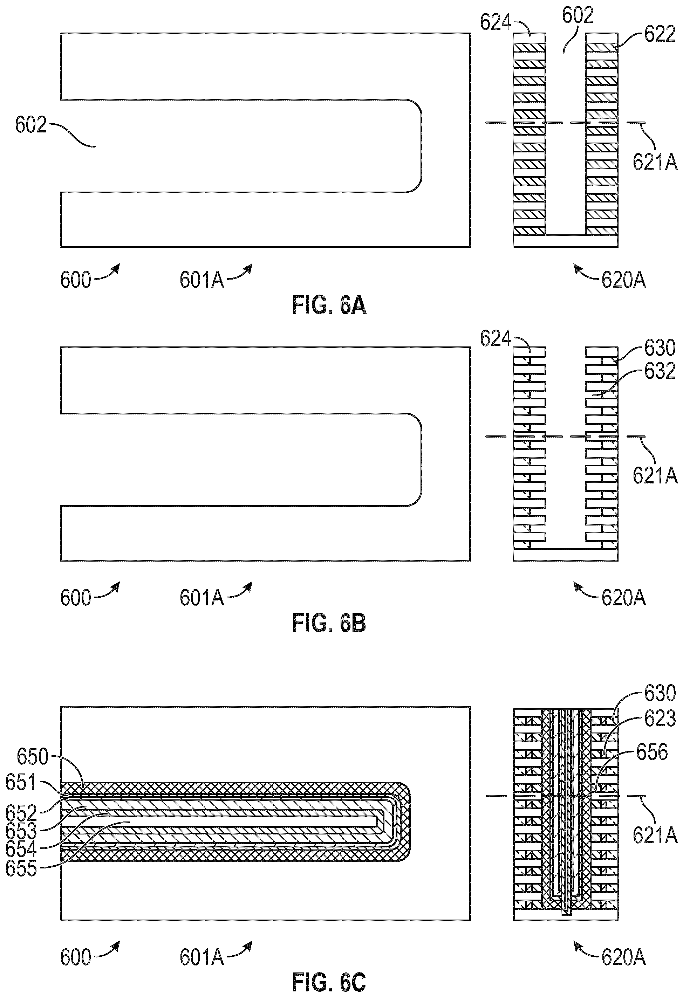

Figures 6A-6K show various stages of manufacture of a memory device 600 similar to memory device 300 from Figures 3 and 4. In Figure 6A, an early stage of the memory device 600 is shown formed from a stack similar to stack 200 from Figure 2. View 601A shows a cross section of view 620A along line 621A. A trench 602 is formed in the stack. The stack includes alternating dielectric layers 624 and sacrificial nitride layers 622. In one example, the dielectric layers include silicon oxide. More specifically, in one example, the dielectric layers 624 include silicon dioxide, although stoichiometry may not be exact.

In Figure 6B, a replacement gate process has been performed. View 601A again shows a cross section of view 620A along line 621A. The nitride layers 622 have been replaced with conductor layers 630. In one example, the conductor layers 630 include metal. In one example, the metal of the conductor layers 630 includes tungsten. Figure 6B further shows a recess operation of the conductor layers 630 into sidewalls of the trench 602. Recesses 632 are formed between dielectric layers 624.

In Figure 6C, a plurality of layers are formed within an interior of the trench 602. View 601A again shows a cross section of view 620A along line 621A. A first sacrificial layer 656, and a second sacrificial layer 650 are included. The first sacrificial layer 656 is formed within the recesses 632 from Figure 6B, and the second sacrificial layer 650 is formed in direct contact with the first sacrificial layer 656. After the second sacrificial layer is formed first within the trench 602, a nitride liner 651, an oxide liner 652 and a polysilicon layer 653 are formed. A second nitride layer 654 and a final oxide layer 655 are formed over the polysilicon layer 653. Figure 6C further shows a high-k layer 623 located between the conductor layers 630 and the first sacrificial layer 656.

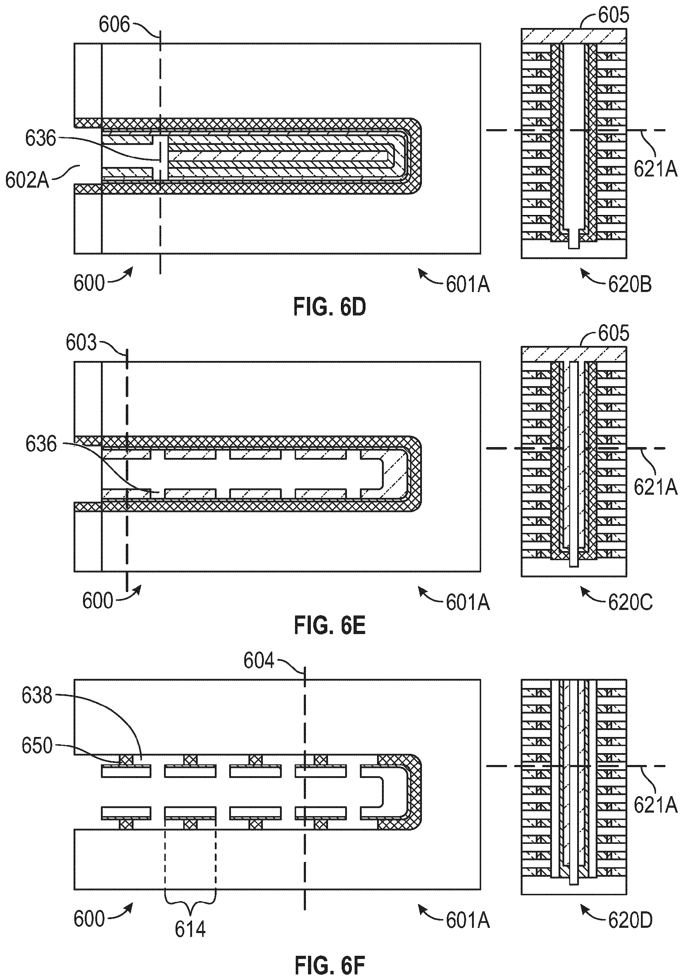

In Figure 6D, a first trim and etch operation is performed within the trench 602, as accessed from a side opening 602A of the trench 602. A cap 605 is temporarily formed over the memory device 600. In one example, the cap 605 includes a tetraethyl orthosilicate (TEOS) cap. View 601A again shows a cross section of view 620B along line 621A. View 620B shows a cross section along line 606. In Figure 6D, a data line access cavity 636 is formed.

In Figure 6E, successive trim and etch operations are performed within the trench 602, as accessed laterally from the side opening 602A. View 601A again shows a cross section of view 620C along line 621A. View 620C shows a cross section along line 603. In Figure 6E a number of data line access cavities 636 are formed by laterally removing material through side opening 602A.

In Figure 6F, portions of the second sacrificial layer 650 are removed through the data line access cavities 636. View 601A again shows a cross section of view 620D along line 621A. View 620D shows a cross section along line 604. In Figure 6F, a plurality of vertical data line cavities 638 are formed by selective removal of portions of the second sacrificial layer 650. In the example of Figure 6F, the vertical data line cavities 638 are arranged in pairs 614 that will later become memory cell pairs similar to memory cell pairs 314.

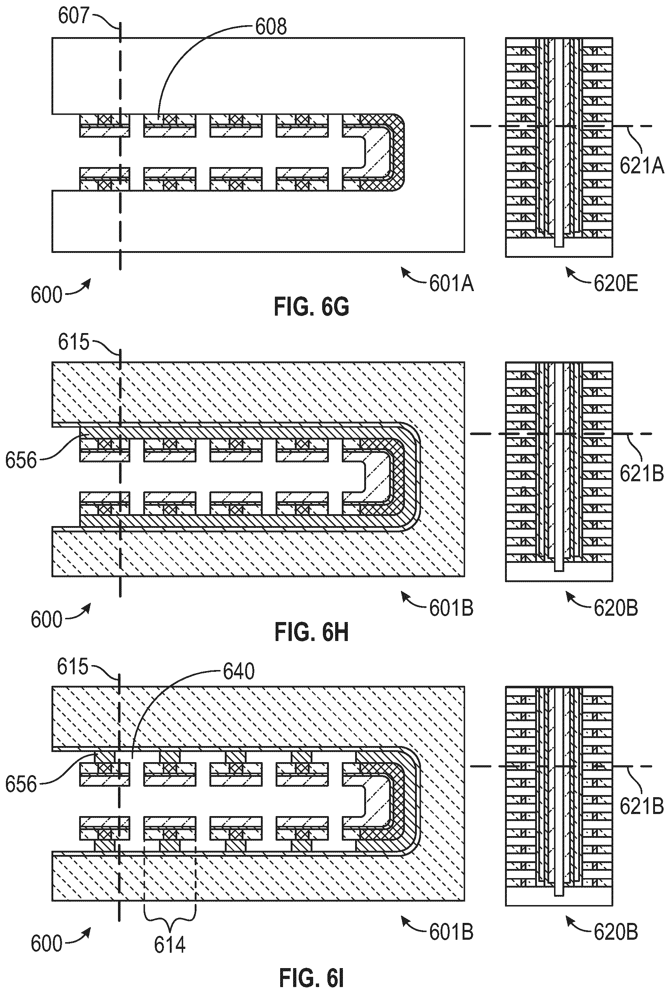

In Figure 6G, the plurality of vertical data line cavities 638 are filled with conductor material to form vertical data lines 608. In one example, the vertical data line cavities 638 are filled with conductor material by an excess deposition of conductor material that is subsequently etched back, leaving only the data line cavities 638 filled with the conductor material. Etching into cavities 638 is slower due to more limited surface area exposure, therefore the cavities remain filled with conductor by stopping the etch at an appropriate time. View 601A again shows a cross section of view 620E along line 621A. View 620E shows a cross section along line 607.

Figure 6H shows a cross section through one of the conductor layers 630. The first sacrificial layer 656 is shown in Figure 6H. View 601B shows a cross section of view 620B along line 621B. View 620B shows a cross section along line 615. In Figure 6I, portions of the first sacrificial layer 656 are removed through the data line access cavities 636. In Figure 6I, a plurality of chalcogenide material cavities 640 are formed by selective removal of portions of the first sacrificial layer 656. In the example of Figure 6I, the vertical data line cavities 640 are arranged in pairs 614 that will later become memory cell pairs similar to memory cell pairs 314.

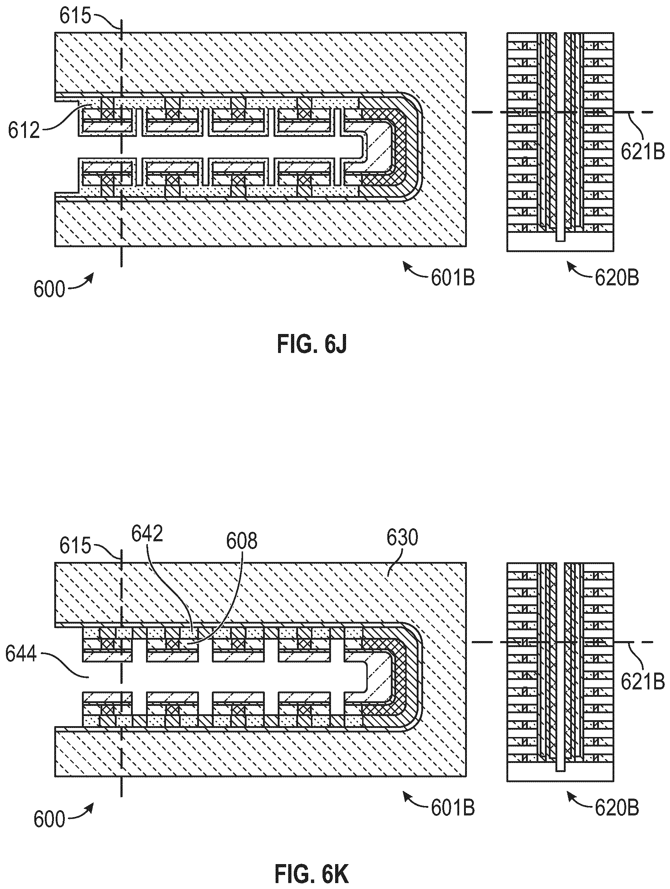

In Figure 6J, the plurality of chalcogenide material cavities 640 are filled with chalcogenide material to form a chalcogenide material layer 612. View 601B again shows a cross section of view 620B along line 621B. View 620B again shows a cross section along line 615. One advantage of the manufacturing process described includes formation of the chalcogenide material layer 612 late in the manufacturing process, after other components such as the vertical data lines 608 have already been formed. Chalcogenide material can be sensitive to processing conditions during other component formation, such as vertical data lines 608. By forming the chalcogenide material layer 612 after forming the vertical data lines 608, an integrity of the chalcogenide material is preserved. In one example, the chalcogenide material includes a phase change material, although the invention is not so limited. Other materials with an ability to change conductivity/resistivity with an application of electricity, heat, etc. are also within the scope of the invention.

In Figure 6K, the chalcogenide material layer 612 is etched back or otherwise selectively removed to form a number of chalcogenide material plugs 642. View 601B again shows a cross section of view 620B along line 621B. View 620B again shows a cross section along line 615. The number of chalcogenide material plugs 642 are electrically coupled between the conducting word line layers 630 and the number of vertical data lines 608. In one example, a remaining space 644 in the trench 602 is later filled with a dielectric material, such as silicon oxide.

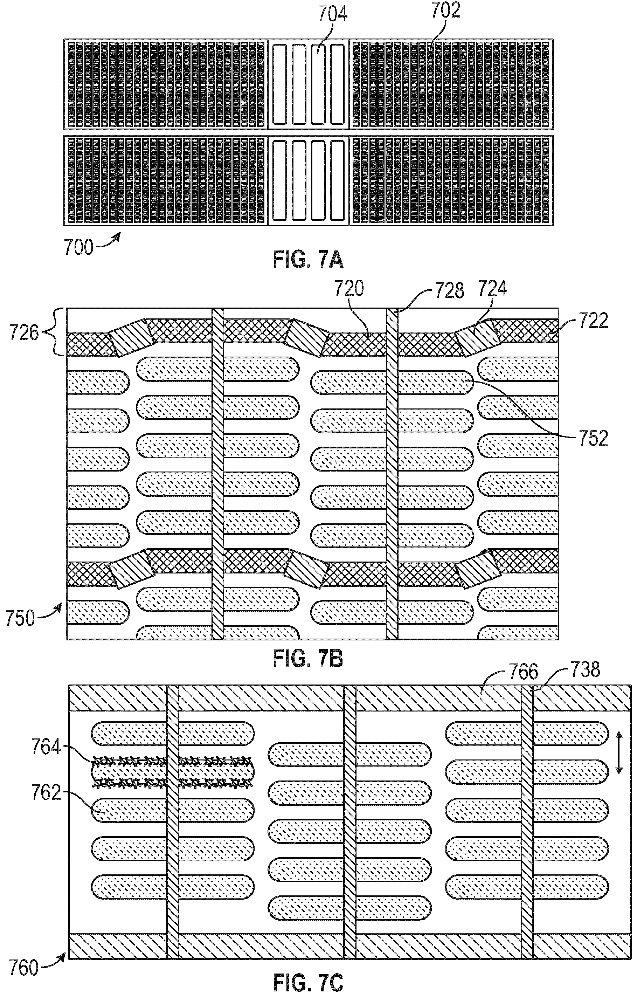

Figure 7A shows a macro view of a memory array 700. The memory array 700 includes a plurality of device trenches 702 similar to the memory devices 300 and 600 described above. A staircase access structure 704 is included within memory array 700 to selectively access the word lines at word line layers 322, 522, 630.

Figure 7B shows another example of a memory array 750. Figure 7B shows a regular array of elongated trenches 752. In one example, the regular array of elongated trenches 752 are staggered as shown in Figure 7B. Figure 7B also shows a plurality of patterns 728 crossing the elongated trenches 752 substantially in the middle, where openings 602A are formed providing access to open ends 304, as described above with reference to Figures 3 and 6. Each half of an elongated trench 752 may include a memory device similar to the memory devices 300 and 600 described above. In Figure 7B, selected elongated trenches 752 are used to form memory devices as described. Other selected elongated trenches 720, 722 are instead filled with a dielectric to form an isolation structure between different groupings of memory devices formed in elongated trenches 752. Figure 7B shows an isolation structure 726 at least partially surrounding one or more memory device elongated trenches 752, the isolation structure 726 including two or more second trenches 720, 722 of the regular array of elongated trenches filled with a dielectric and connected together by one or more joining trenches 724.

Figure 7C shows another example of a memory array 760. Figure 7C shows a regular array of elongated trenches 762. Each elongated trench is divided in halves by a respective pattern 738, where openings 602A are formed providing access to open ends 304, as described above with reference to Figures 3 and 6. Each half of an elongated trench 762 may include a memory device similar to the memory devices 300 and 600 described above. Individual memory cells as described in examples above are located in locations 764 as indicated in Figure 7C. In Figure 7C, a slit 766 is cut into the wafer where the elongated trenches 762 are formed. The slit 766 is filled with a dielectric to form an isolation structure.

One advantage of using elongated trenches from an already existing array of elongated trenches as shown in Figure 7B includes manufacturing efficiency. It may be easier and less costly to form joining trenches 724 and to fill existing second trenches 720, 722 to form the isolation structure 726 as compared to forming a slit 766.

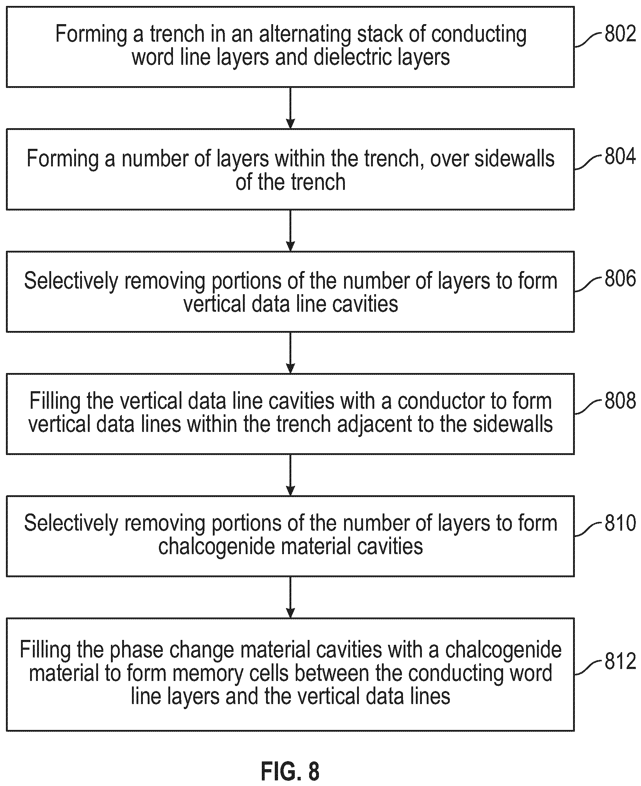

Figure 8 shows a flow diagram of an example method of manufacture of memory devices as described. In operation 802, a trench is formed in an alternating stack of conducting word line layers and dielectric layers. In operation 804, a number of layers are formed within the trench, over sidewalls of the trench. In operation 806, portions of the number of layers are selectively removed to form vertical data line cavities. In operation 808, the vertical data line cavities are filled with a conductor to form vertical data lines within the trench adjacent to the sidewalls. In operation 810, portions of the number of layers are selectively removed to form chalcogenide material cavities, and in operation 812, the chalcogenide material cavities are filled with a chalcogenide material to form memory cells between the conducting word line layers and the vertical data lines.

In one example, selectively removing portions of the number of layers to form vertical data line cavities includes forming cavities on both sides of trench. In one example, forming cavities on both sides of trench includes forming "T" shaped cavities. Examples of "T" shaped cavities are shown, at least in Figures 6F. Other "T" shaped cavities are shown in Figure 6I.

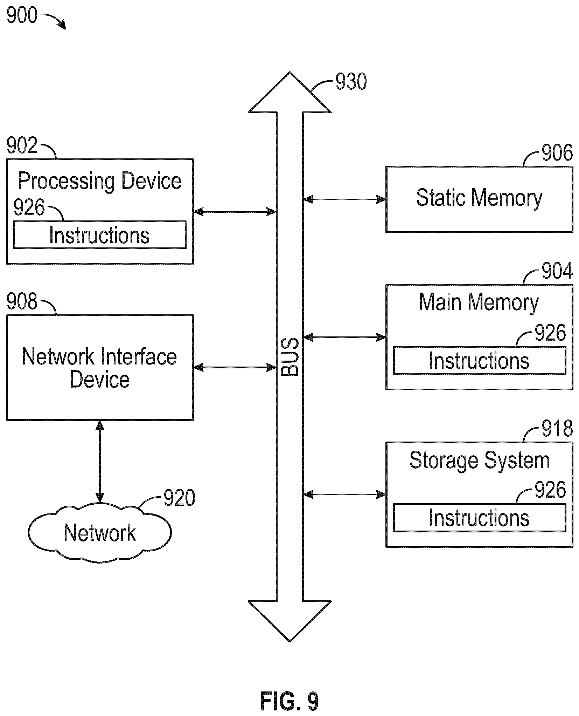

FIG. 9 illustrates a block diagram of an example machine (e.g., a host system) 900 which may include one or more chalcogenide memory cells, memory devices and/or memory systems as described above. As discussed above, machine 900 may benefit from enhanced memory performance from use of one or more of the described transistor structures and/or memory systems, facilitating improved performance of machine 900 (as for many such machines or systems, efficient reading and writing of memory can facilitate improved performance of a processor or other components that machine, as described further below.

In alternative embodiments, the machine 900 may operate as a standalone device or may be connected (e.g., networked) to other machines. In a networked deployment, the machine 900 may operate in the capacity of a server machine, a client machine, or both in server-client network environments. In an example, the machine 900 may act as a peer machine in peer-to-peer (P2P) (or other distributed) network environment. The machine 900 may be a personal computer (PC), a tablet PC, a set-top box (STB), a personal digital assistant (PDA), a mobile telephone, a web appliance, an loT device, automotive system, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

Examples, as described herein, may include, or may operate by, logic, components, devices, packages, or mechanisms. Circuitry is a collection (e.g., set) of circuits implemented in tangible entities that include hardware (e.g., simple circuits, gates, logic, etc.). Circuitry membership may be flexible over time and underlying hardware variability. Circuitries include members that may, alone or in combination, perform specific tasks when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a computer-readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable participating hardware (e.g., the execution units or a loading mechanism) to create members of the circuitry in hardware via the variable connections to carry out portions of the specific tasks when in operation. Accordingly, the computer-readable medium is communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time.

The machine (e.g., computer system, a host system, etc.) 900 may include a processing device 902 (e.g., a hardware processor, a central processing unit (CPU), a graphics processing unit (GPU), a hardware processor core, or any combination thereof, etc.), a main memory 904 (e.g., read-only memory (ROM), dynamic random-access memory (DRAM) such as synchronous DRAM (SDRAM) or Rambus DRAM (RDRAM), etc.), a static memory 906 (e.g., static random-access memory (SRAM), etc.), and a storage system 918, some or all of which may communicate with each other via a communication interface (e.g., a bus) 930. In one example, the main memory 904 includes one or more memory devices as described in examples above.

The processing device 902 can represent one or more general-purpose processing devices such as a microprocessor, a central processing unit, or the like. More particularly, the processing device can be a complex instruction set computing (CISC) microprocessor, reduced instruction set computing (RISC) microprocessor, very long instruction word (VLIW) microprocessor, or a processor implementing other instruction sets, or processors implementing a combination of instruction sets. The processing device 902 can also be one or more special-purpose processing devices such as an application specific integrated circuit (ASIC), a field programmable gate array (FPGA), a digital signal processor (DSP), network processor, or the like. The processing device 902 can be configured to execute instructions 926 for performing the operations and steps discussed herein. The computer system 900 can further include a network interface device 908 to communicate over a network 920.

The storage system 918 can include a machine-readable storage medium (also known as a computer-readable medium) on which is stored one or more sets of instructions 926 or software embodying any one or more of the methodologies or functions described herein. The instructions 926 can also reside, completely or at least partially, within the main memory 904 or within the processing device 902 during execution thereof by the computer system 900, the main memory 904 and the processing device 902 also constituting machine-readable storage media.

The term "machine-readable storage medium" should be taken to include a single medium or multiple media that store the one or more sets of instructions, or any medium that is capable of storing or encoding a set of instructions for execution by the machine and that cause the machine to perform any one or more of the methodologies of the present disclosure. The term "machine-readable storage medium" shall accordingly be taken to include, but not be limited to, solid-state memories, optical media, and magnetic media. In an example, a massed machine-readable medium comprises a machine-readable medium with multiple particles having invariant (e.g., rest) mass. Accordingly, massed machine-readable media are not transitory propagating signals. Specific examples of massed machine-readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; and CD-ROM and DVD-ROM disks.

The machine 900 may further include a display unit, an alphanumeric input device (e.g., a keyboard), and a user interface (UI) navigation device (e.g., a mouse). In an example, one or more of the display unit, the input device, or the UI navigation device may be a touch screen display. The machine may further include a signal generation device (e.g., a speaker), or one or more sensors, such as a global positioning system (GPS) sensor, compass, accelerometer, or one or more other sensor. The machine 900 may include an output controller, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

The instructions 926 (e.g., software, programs, an operating system (OS), etc.) or other data are stored on the storage system 918 can be accessed by the main memory 904 for use by the processing device 902. The main memory 904 (e.g., DRAM) is typically fast, but volatile, and thus a different type of storage than the storage system 918 (e.g., an SSD), which is suitable for long-term storage, including while in an "off" condition. The instructions 926 or data in use by a user or the machine 900 are typically loaded in the main memory 904 for use by the processing device 902. When the main memory 904 is full, virtual space from the storage system 918 can be allocated to supplement the main memory 904; however, because the storage system 918 device is typically slower than the main memory 904, and write speeds are typically at least twice as slow as read speeds, use of virtual memory can greatly reduce user experience due to storage system latency (in contrast to the main memory 904, e.g., DRAM). Further, use of the storage system 918 for virtual memory can greatly reduce the usable lifespan of the storage system 918.

The instructions 926 may further be transmitted or received over a network 920 using a transmission medium via the network interface device 908 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.15 family of standards known as Wi-Fi^{®}, IEEE 802.16 family of standards known as WiMax^{®}), IEEE 802.15.4 family of standards, peer-to-peer (P2P) networks, among others. In an example, the network interface device 908 may include one or more physical jacks (e.g., Ethernet, coaxial, or phone jacks) or one or more antennas to connect to the network 920. In an example, the network interface device 908 may include multiple antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding, or carrying instructions for execution by the machine 900, and includes digital or analog communications signals or other intangible medium to facilitate communication of such software.

The above detailed description includes references to the accompanying drawings, which form a part of the detailed description. The drawings show, by way of illustration, specific embodiments in which the invention can be practiced. These embodiments are also referred to herein as "examples". Such examples can include elements in addition to those shown or described. However, the present inventor also contemplates examples in which only those elements shown or described are provided. Moreover, the present inventor also contemplates examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein". Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

In various examples, the components, controllers, processors, units, engines, or tables described herein can include, among other things, physical circuitry or firmware stored on a physical device. As used herein, "processor" means any type of computational circuit such as, but not limited to, a microprocessor, a microcontroller, a graphics processor, a digital signal processor (DSP), or any other type of processor or processing circuit, including a group of processors or multi-core devices.

The terms "wafer" is used herein to refer generally to any structure on which integrated circuits are formed, and also to such structures during various stages of integrated circuit fabrication. The term "substrate" is used to refer to either a wafer, or other structures which support or connect to other components, such as memory die or portions thereof. Thus, the term "substrate" embraces, for example, circuit or "PC" boards, interposers, and other organic or non-organic supporting structures (which in some cases may also contain active or passive components). The following detailed description is, therefore, not to be taken in a limiting sense, and the scope of the various embodiments is defined only by the appended claims, along with the full scope of equivalents to which such claims are entitled.

It will be understood that when an element is referred to as being "on," "connected to" or "coupled with" another element, it can be directly on, connected, or coupled with the other element or intervening elements may be present. In contrast, when an element is referred to as being "directly on," "directly connected to" or "directly coupled with" another element, there are no intervening elements or layers present. If two elements are shown in the drawings with a line connecting them, the two elements can be either be coupled, or directly coupled, unless otherwise indicated.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer-readable instructions for performing various methods. The code may form portions of computer program products. Further, the code can be tangibly stored on one or more volatile or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

To better illustrate the method and apparatuses disclosed herein, a non-limiting list of embodiments is provided here:

An example of subject matter (e.g., a chalcogenide memory device) may comprise means for conducting word lines in alternating layers with dielectric layers, means for forming a trench in the alternating layers, means for extending vertical data lines upward within the trench normal to the layers, means for isolating regions in a middle portion of the trench to separate vertical data lines on either side, and means for electrically coupling chalcogenide material plugs between the conducting word line layers and the vertical data lines while maintaining electrical isolation from one another.

In an example, which may be combined with any one or more examples described herein, the means for conducting word lines comprises an alternating stack of conducting word line layers and dielectric layers, the means for forming a trench comprises a trench in the alternating stack, the means for extending vertical data lines comprises a number of vertical data lines extending upward within the trench normal to layers in the alternating stack, the means for isolating regions comprises an isolation region in a middle portion of the trench separating vertical data lines on either side of the trench, and the means for electrically coupling comprises a number of chalcogenide material plugs electrically isolated from one another and electrically coupled between the conducting word line layers and the number of vertical data lines.

An example of subject matter (e.g., a chalcogenide memory device) may comprise an alternating stack of conducting word line layers and dielectric layers, a trench in the alternating stack of conducting word line layers and dielectric layers, a number of vertical data lines extending upward within the trench normal to layers in the alternating stack of conducting word line layers and dielectric layers, an isolation region in a middle portion of the trench separating vertical data lines on either side of the trench, and a number of chalcogenide material plugs electrically isolated from one another and electrically coupled between the conducting word line layers and the number of vertical data lines.

In an example, which may be combined with any one or more examples described herein, the conducting word line layers optionally include tungsten.

In an example, which may be combined with any one or more examples described herein, the chalcogenide material optionally includes a phase change material.

In an example, which may be combined with any one or more examples described herein, the vertical data lines are optionally arranged in vertical paired columns separated by dielectric along sidewalls of the trench.

In an example, which may be combined with any one or more examples described herein, the number of vertical data lines optionally include tungsten and the subject matter may optionally comprise an intermediate electrode conductor between the word line layers and the chalcogenide material and an intermediate electrode conductor between the vertical data lines and the chalcogenide material.

An example of subject matter (e.g., a chalcogenide memory device) may comprise an alternating stack of conducting word line layers and dielectric layers, a regular array of elongated trenches in the alternating stack of conducting word line layers and dielectric layers, a number of vertical data lines extending upward normal to layers in the alternating stack of conducting word line layers and dielectric layers within a first elongated trench of the regular array of elongated trenches, a number of chalcogenide material plugs electrically isolated from one another and electrically coupled between the conducting word line layers and the number of vertical data lines, and an isolation structure at least partially surrounding the first trench, the isolation structure including two or more second trenches of the regular array of elongated trenches filled with a dielectric and connected together by one or more joining trenches.

In an example, which may be combined with any one or more examples described herein, the regular array of elongated trenches optionally includes staggered elongated trenches.

In an example, which may be combined with any one or more examples described herein, the subject matter may optionally comprise an isolation region in a middle portion of the first elongated trench separating vertical data lines on either side of the trench.

In an example, which may be combined with any one or more examples described herein, the conducting word line layers optionally include tungsten and the chalcogenide material optionally includes phase change material.

In an example, which may be combined with any one or more examples described herein, the vertical data lines are optionally arranged in vertical paired columns separated by dielectric along sidewalls of the trench and the number of vertical data lines optionally include tungsten.

An example of subject matter (e.g., method) may comprise forming a trench in an alternating stack of conducting word line layers and dielectric layers, forming a number of layers within the trench over sidewalls of the trench, selectively removing portions of the number of layers to form vertical data line cavities, filling the vertical data line cavities with a conductor to form vertical data lines within the trench adjacent to the sidewalls, selectively removing portions of the number of layers to form chalcogenide material cavities, and filling the chalcogenide material cavities with a chalcogenide material to form memory cells between the conducting word line layers and the vertical data lines.

In an example, which may be combined with any one or more examples described herein, the chalcogenide material is optionally deposited after the vertical data lines.

In an example, which may be combined with any one or more examples described herein, selectively removing portions optionally includes laterally removing portions of the number of layers to form vertical data line cavities and laterally removing portions optionally includes sequentially forming cavities in a lateral progression.

In an example, which may be combined with any one or more examples described herein, selectively removing portions of the number of layers to form vertical data line cavities optionally includes forming cavities on both sides of the trench and forming cavities on both sides of the trench optionally includes forming "T" shaped cavities.

In an example, which may be combined with any one or more examples described herein, selectively removing portions of the number of layers to form chalcogenide material cavities optionally includes forming "T" shaped cavities.

In an example, a system, method, or apparatus may optionally combine any portion or combination of any portion of any one or more of the examples described herein, may optionally combine any portion or combination of any portion of any one or more of the examples described herein to comprise "means for" performing any portion of any one or more of the functions, operations, or methods of the examples described herein.

The above description is intended to be illustrative, and not restrictive. For example, the above-described examples (or one or more aspects thereof) may be used in combination with each other. Other embodiments can be used, such as by one of ordinary skill in the art upon reviewing the above description. The Abstract is provided to comply with 37 C.F.R. §1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment, and it is contemplated that such embodiments can be combined with each other in various combinations or permutations. The scope of the invention is defined by the appended claims.

## Claims

1. A chalcogenide memory device, comprising:
an alternating stack of conducting word line layers and dielectric layers;
a trench in the alternating stack of conducting word line layers and dielectric layers;
a number of vertical data lines extending upward within the trench normal to layers in the alternating stack of conducting word line layers and dielectric layers;
an isolation region in a middle portion of the trench, separating vertical data lines on either side of the trench; and
a number of chalcogenide material plugs electrically isolated from one another, the number of chalcogenide material plugs electrically coupled between the conducting word line layers and the number of vertical data lines.

2. The chalcogenide memory device of claim 1, further including an intermediate electrode conductor between the word line layers and the chalcogenide material.

3. The chalcogenide memory device of claim 2, further including an intermediate electrode conductor between the vertical data lines and the chalcogenide material.

4. A chalcogenide memory device, comprising:
an alternating stack of conducting word line layers and dielectric layers;
a regular array of elongated trenches in the alternating stack of conducting word line layers and dielectric layers;
a number of vertical data lines extending upward normal to layers in the alternating stack of conducting word line layers and dielectric layers within a first elongated trench of the regular array of elongated trenches;
a number of chalcogenide material plugs electrically isolated from one another, the number of chalcogenide material plugs electrically coupled between the conducting word line layers and the number of vertical data lines; and
an isolation structure at least partially surrounding the first trench, the isolation structure including two or more second trenches of the regular array of elongated trenches filled with a dielectric and connected together by one or more joining trenches.

5. The chalcogenide memory device of claim 4, wherein the regular array of elongated trenches includes staggered elongated trenches and optionally further including an isolation region in a middle portion of the first elongated trench, separating vertical data lines on either side of the trench.

6. The chalcogenide memory device of any preceding claim, wherein the conducting word line layers include tungsten.

7. The chalcogenide memory device of any preceding claim, wherein the chalcogenide material includes phase change material.

8. The chalcogenide memory device of any preceding claim, wherein the vertical data lines are arranged in vertical paired columns separated by dielectric along sidewalls of the trench.

9. The chalcogenide memory device of any preceding claim, wherein the number of vertical data lines include tungsten.

10. A method, comprising:
forming a trench in an alternating stack of conducting word line layers and dielectric layers;
forming a number of layers within the trench, over sidewalls of the trench;
selectively removing portions of the number of layers to form vertical data line cavities;
filling the vertical data line cavities with a conductor to form vertical data lines within the trench adjacent to the sidewalls;
selectively removing portions of the number of layers to form chalcogenide material cavities; and
filling the chalcogenide material cavities with a chalcogenide material to form memory cells between the conducting word line layers and the vertical data lines.

11. The method of claim 10, wherein the chalcogenide material is deposited after the vertical data lines.

12. The method of either of claims 10 to 11, wherein selectively removing portions includes laterally removing portions of the number of layers to form vertical data line cavities.

13. The method of claim 12, wherein laterally removing portions includes sequentially forming cavities in a lateral progression.

14. The method of any of claims 10 to 13, wherein selectively removing portions of the number of layers to form vertical data line cavities includes forming cavities on both sides of the trench and optionally wherein forming cavities on both sides of the trench includes forming "T" shaped cavities.

15. The method of any of claims 10 to 13, wherein selectively removing portions of the number of layers to form chalcogenide material cavities includes forming "T" shaped cavities.
